# EUROPEAN PATENT APPLICATION

(11) **EP 2 420 598 A1**
(43) Date of publication of application: **22.02.2012**
(21) Application number: 10764335.5
(22) Date of filing: 19.03.2010
(51) Int. Cl.: C30B 29/36, C30B 23/06

(54) **APPARATUS FOR PRODUCING SILICON CARBIDE SINGLE CRYSTAL AND METHOD FOR PRODUCING SILICON CARBIDE SINGLE CRYSTAL**

(30) Priority: 16.04.2009 JP 2009100295
(71) Applicant: Bridgestone Corporation, Tokyo 104-8340 (JP)
(72) Inventor: OKUNO, Kenichiro, Kodaira-shi Tokyo 187-8531 (JP)
(74) Representative: Oxley, Robin John George
(86) International application number: PCT/JP2010/054860
(87) International publication number: WO 2010/119749

(57) **Abstract**

Disclosed is an apparatus (1) for manufacturing a silicon carbide single crystal, which comprises: a crucible main body (11) that is opened at the top and holds a sublimation material (50) in the bottom portion (11a); a cover member (12) which covers the upper opening (11b) of the crucible main body (11); and a cylindrical guide member (70) which is provided in the crucible main body (11) for guiding the growth of the silicon carbide single crystal when the silicon carbide single crystal is grown from a seed crystal (60). The guide member (70) is separably configured of a first divided body and a second divided body.

## Description

### TECHNICAL FIELD

The present invention relates to an apparatus of manufacturing a silicon carbide single crystal by using a sublimation recrystallization method and a method of manufacturing a silicon carbide single crystal.

### BACKGROUND ART

Since a silicon carbide single crystal has better physical properties as compared with a generally used silicon single crystal and can be used for significantly improving the performance of an LED, a semiconductor device and the like, the silicon carbide single crystal is significantly expected as the next generation material. There has been disclosed an apparatus of manufacturing a silicon carbide single crystal (hereinafter, referred to as a single crystal, where appropriate) using a seed crystal and a sublimation material, which include silicon carbide. In general, the manufacturing apparatus includes a crucible main body for accommodating a powdery sublimation material including silicon carbide in the bottom portion thereof, a cover member for covering the upper opening of the crucible main body and provided on the rear surface thereof with a seed crystal including silicon carbide, and a cylindrical guide member provided to the inside of the crucible main body to guide a grown crystal when the seed crystal is grown (see

### Patent Document 1),

### PRIOR ART DOCUMENT

### PATENT DOCUMENT

Patent Document 1: JP-A-2004-224663 (page 4, Fig, 1)

### SUMMARY OF THE INVENTION

However, in the above-mentioned conventional art, since a grown single crystal is attached to the guide member, a crack may occur from a contact portion between the single crystal and the guide member when taking the completely grown single crystal off from the guide member and performing slicing machining for the single crystal.

Therefore, the present invention has been achieved in view of the above-described problems, and an object thereof is to provide an apparatus and a method of manufacturing a silicon carbide single crystal which prevent an occurrence of a crack from a contact portion between a single crystal and a guide member in a process of cutting the completely grown single crystal away from the guide member, even if the guide member is provided.

The present invention for solving the above-mentioned problems has the following characteristics.

First, a feature of the present invention is summarized as an apparatus of manufacturing a silicon carbide single crystal, including: a crucible main body (crucible main body 11) which is opened at a top and accommodates a sublimation material (sublimation material 50) in a bottom portion (bottom portion 11a); a cover member (cover member 12) which covers an upper opening (upper opening 11b) of the crucible main body and is provided on a rear surface of the cover member with a seed crystal (seed crystal 60); and a cylindrical guide member (guide member 70) which is provided in the crucible main body to introduce a sublimated raw material gas from the sublimation material to the seed crystal and to guide growth of the silicon carbide single crystal when the silicon carbide single crystal is grown from the seed crystal, wherein the guide member includes a plurality of divided bodies (first divided body 74, second divided body 75). Consequently, since it has only to separate a plurality of divided bodies from each other when taking the completely grown single crystal off from the guide member, it is possible to easily take the single crystal off from the guide member and appropriately prevent the occurrence of the damage (e.g., a crack) of the single crystal.

The other feature is summarized as a gap (gap (ou), gap (in)) is provided between the divided bodies.

The other feature is summarized as a method of manufacturing a silicon carbide single crystal, the method including: a first step of generating raw material gas by heating and sublimating a sublimation material (sublimation material 50) including silicon carbide and accommodated in a crucible main body (crucible main body 11); a second step of growing a seed crystal (seed crystal 60), which receives the raw material gas (raw material gas G) via a guide member (guide member 70) including a plurality of divided bodies (first divided body 74, second divided body 75), into a silicon carbide single crystal while being guided by the guide member; and a third step of taking off the grown silicon carbide single crystal after separating the plurality of divided bodies from the grown silicon carbide single crystal.

According to the present invention, it is possible to provide an apparatus of manufacturing a silicon carbide single crystal capable of easily taking a single crystal off from a guide member and appropriately preventing the occurrence of the damage (e.g., a crack) of the single crystal, and to provide a method of manufacturing a silicon carbide single crystal.

### BRIEF DESCRIPTION OF THE DRAWINGS

[Fig. 1] Fig. 1 is a sectional view illustrating the outline of an apparatus of manufacturing a silicon carbide single crystal according to an embodiment of the present invention.
[Fig. 2] Fig. 2 is a side view of a partial section of the guide member in Fig. 1 when viewed from the side.
[Fig. 3] Fig. 3 is a plan view of the guide member in Fig. 2 when viewed from the top.
[Fig. 4] Fig. 4 is a partial enlarged view of the section taken along line A-A of Fig. 2.
[Fig. 5] Fig. 5 is an enlarged sectional view illustrating the state in which a first divided body is separated from a second divided body.

### MODES FOR CARRYING OUT THE INVENTION

Hereinafter, an embodiment of an apparatus of manufacturing a silicon carbide single crystal according to the present invention will be described with reference to the accompanying drawings. In the following drawings, the same or similar reference numerals are used to designate the same or similar parts, It will be appreciated that the drawings are schematically shown and the ratio and the like of each dimension are different from the real ones.

Therefore, detailed dimension and the like should be determined considering the following description. Of course, among the drawings, the dimensional relationship and the ratio are different.

### (Embodiment)

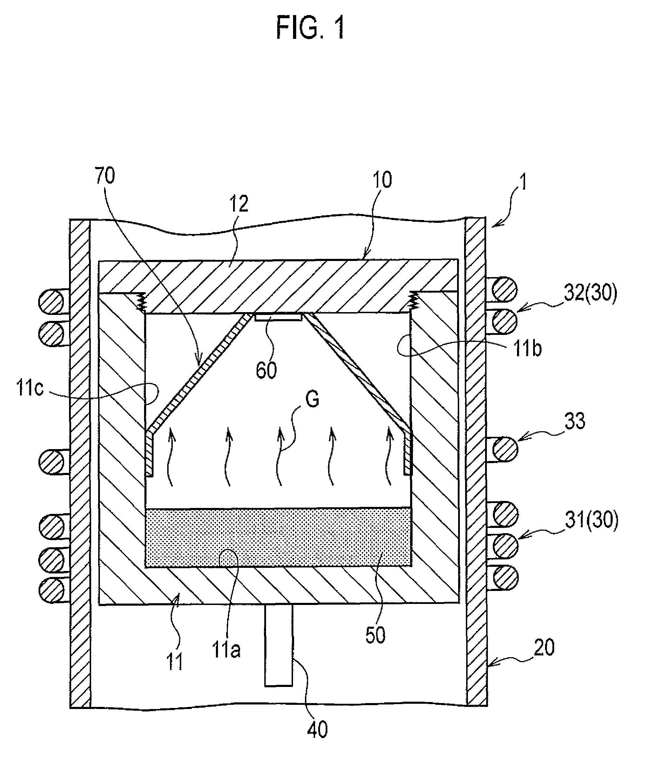

An apparatus of manufacturing a silicon carbide single crystal 1 according to an embodiment of the present invention will be described with reference to Fig. 1.

Fig. 1 is a sectional view illustrating the outline of the apparatus of manufacturing a silicon carbide single crystal according to the embodiment of the present invention.

As illustrated in Fig. 1, the apparatus of manufacturing a silicon carbide single crystal 1 includes a graphite crucible 10, a quartz tube 20 for covering at least the lateral side of the graphite crucible 10, and an induction heating coil 30 arranged at an outer periphery of the quartz tube 20.

The graphite crucible 10 includes a crucible main body 11, a cover member 12, and a guide member 70, and is fixed to the inside of the quartz tube 20 in a movable manner by a support rod 40.

A sublimation material 50 (powder including silicon carbide) is accommodated in the bottom portion 11a of the crucible main body 11. The cover member 12 closes the upper opening 11b of the crucible main body 11 and is detachably coupled to the inner peripheral surface of the upper end portion of the crucible main body 11 through screw coupling. Further, a seed crystal 60 including silicon carbide is attached to the rear surface of the cover member 12. The seed crystal 60 may be supported by mechanical coupling such as screwing or bonding using adhesive. Further, the cylindrical guide member 70 is fitted with the inner side surface 11c of the crucible main body 11. The upper end of the guide member 70 covers the outer periphery of the seed crystal 60 fixed to the rear surface of the cover member 12.

A sublimation material 50 is a powdery silicon carbide material including silicon carbide. If the inside of the graphite crucible 10 reaches predetermined temperature and pressure conditions, the sublimation material 50 is sublimated to become raw material gas G and the raw material gas G is recrystallized and grown on the seed crystal 60, resulting in the formation of a silicon carbide single crystal.

Further, the induction heating coil 30 includes a first induction heating coil 31 arranged at a height position corresponding to the bottom portion 11a of the crucible main body 11, and a second induction heating coil 32 arranged at a height position corresponding to the seed crystal 60 supported to the rear surface of the cover member 12.

The height position of the graphite crucible 10 is changed by moving the support rod 40, so that the sublimation material 50 accommodated in the bottom portion 11a of the crucible main body 11 can be made corresponding to the height position of the first induction heating coil 31, and the seed crystal 60 supported to the cover member 12 can be made corresponding to the height position of the second induction heating coil 32.

In addition, an interference preventive coil 33 is provided between the first induction heating coil 31 and the second induction heating coil 32. A current is allowed to flow through the interference preventive coil 33, so that it is possible to prevent interference between a current flowing through the first induction heating coil 31 and a current flowing through the second induction heating coil 32.

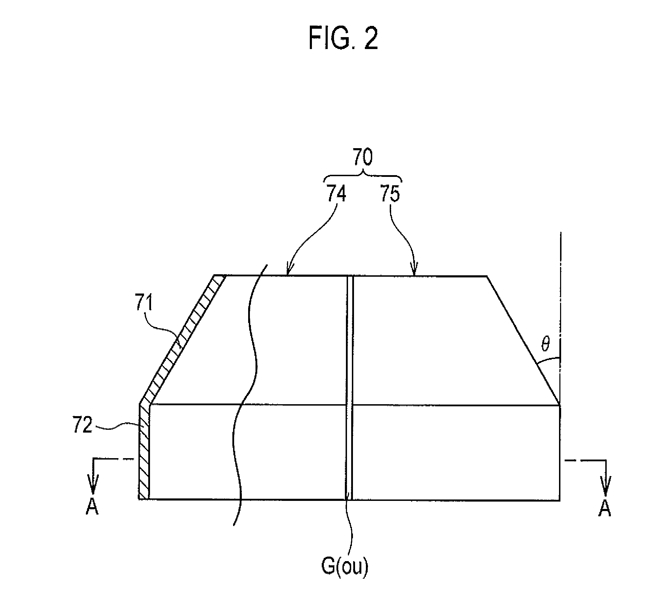

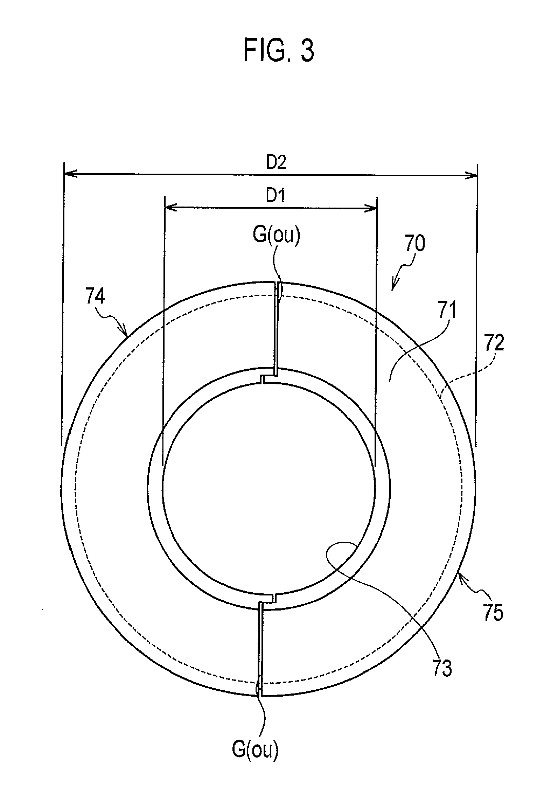

Fig. 2 is a side view of a partial section of the guide member in Fig. 1 when viewed from the side. Fig. 3 is a plan view of the guide member in Fig. 2 when viewed from the top.

As illustrated in Fig. 2, the guide member 70 according to the present embodiment has an approximately cylindrical shape, and includes an inclined portion 71 arranged at the upper side and a vertical wall portion 72 arranged at the lower side, which are integrally formed with each other. The guide member 70 is made of graphite,

As illustrated in Fig. 2, the inclined portion 71 has a circular truncated cone shape in side view. The vertical wall portion 72 has a rectangular shape in side view. Further, as illustrated in Fig. 3, the inclined portion 71 is formed at the upper end thereof with a circular opening 73 in planar view. The inner diameter D1 of the opening 73 is larger than the outer diameter of the seed crystal 60 (see Fig. 1).

Further, the inner side surface 11c of the crucible main body 11 illustrated in Fig. 1 has a cylindrical shape, and the inner diameter of the inner side surface 11c is slightly larger than the outer diameter D2 of the vertical wall portion 72. Therefore, the guide member 70 is efficiently fitted with the inner side surface 11c of the crucible main body 11.

Further, the guide member 70 includes a first divided body 74 and a second divided body 75, and is divided into two about the center in the radial direction. A small gap G (ou) is formed at a joint portion between the first divided body 74 and the second divided body 75 along the circumferential direction.

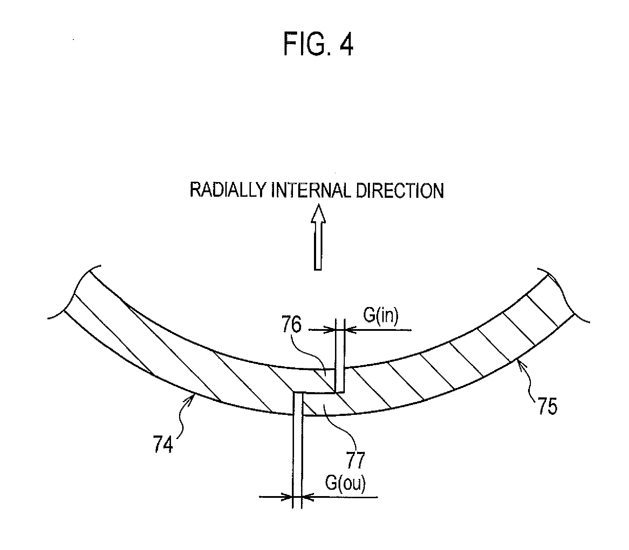

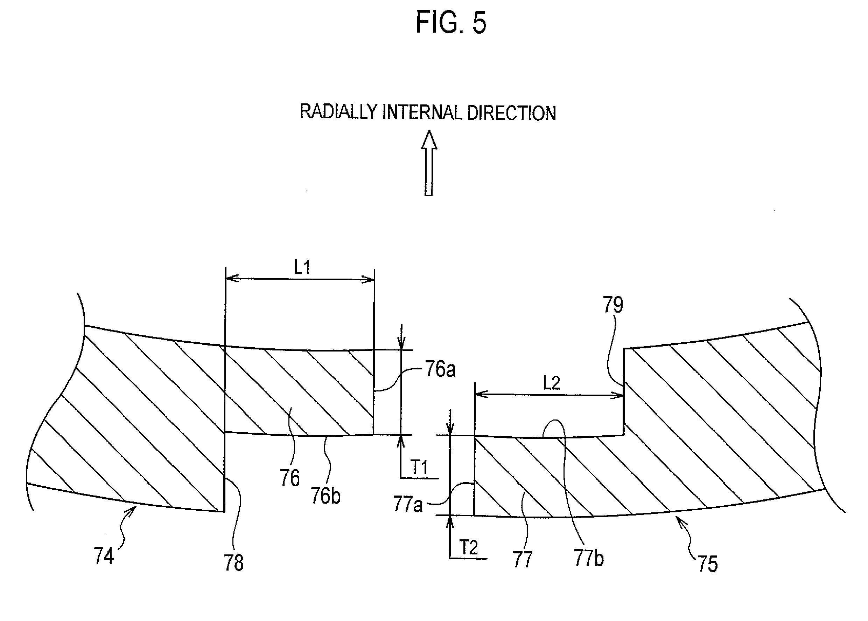

Fig. 4 is a partial enlarged view of the section taken along line A-A of Fig. 2. Fig. 5 is an enlarged sectional view illustrating the state in which the first divided body is separated from the second divided body.

As illustrated in Figs. 4 and 5, a first protrusion 76 is formed at the radial inside of the circumferential end of the first divided body 74. A second protrusion 77 is formed at the radial outside of the circumferential end of the second divided body 75.

The first protrusion 76 is provided at the circumferential front end thereof with a protrusion end surface 76a. The first protrusion 76 is provided at the radial outside thereof with a protrusion outer peripheral surface 76b. The radial length (thickness) of the protrusion end surface 76a is set to T1 and the circumferential length of the protrusion outer peripheral surface 76b is set to L1. Further, the first protrusion 76 is provided at the radial outside thereof with a radial outside end surface 78 which extends outward in the radial direction and is connected to the protrusion outer peripheral surface 76b.

Meanwhile, the second protrusion 77 is provided at the circumferential front end thereof with a protrusion end surface 77a. The second protrusion 77 is provided at the radial inside thereof with a protrusion inner peripheral surface 77b. The radial length (thickness) of the protrusion end surface 77a is set to T2 and the circumferential length of the protrusion inner peripheral surface 77b is set to L2. Further, the second protrusion 77 is provided at the radial inside thereof with a radially-internal end surface 79 which extends inward in the radial direction and is connected to the protrusion inner peripheral surface 77b.

Consequently, the first divided body 74 is engaged with the second divided body 75 in the state in which the protrusion outer peripheral surface 76b is brought into contact with the protrusion inner peripheral surface 77b, thereby forming the guide member 70. Further, as illustrated in Fig. 4, the first divided body 74 is allowed to circumferentially separate from or approach the second divided body 75, so that it is possible to appropriately adjust the outer peripheral gap G (ou) and the inner peripheral gap G (in).

Further, in the stage before single crystal growth is completed, the gap G (ou) and the gap G (in) are changed, so that it is possible to adjust an angle θ (see Fig. 2) of the inclined portion 71 with respect to the vertical direction. For example, in the state in which an initial angle θ is set to 30 degrees and the seed crystal 60 is grown, the angle µ may be changed to 45 degrees at the time at which the growth height of a single crystal reaches 0.5 mm to several mm. Consequently, it is possible to expand the diameter of a single crystal without degradation in quality.

Hereinafter, a method of manufacturing a single crystal according to the present embodiment will be briefly described.

First, in the first step, as illustrated in Fig. 1, the sublimation material 50 including silicon carbide is accommodated in the crucible main body 11, and the seed crystal 60 is fixed to the rear surface of the cover member 12. A current is allowed to flow through the first induction heating coil 31, the second induction heating coil 32, and the interference preventive coil 33 to heat and sublimate the sublimation material 50, thereby generating the raw material gas G.

In the second step, the raw material gas G rises and is recrystallized on the seed crystal 60 while being guided by the cylindrical guide member 70, so that the seed crystal 60 is grown into a silicon carbide single crystal.

In the third step, the grown silicon carbide single crystal and the guide member 70 are taken off, and the first divided body 74 and the second divided body 75 are separated from the silicon carbide single crystal.

In addition, the taken silicon carbide single crystal is subject to peripheral grinding machining, for example, in order to obtain a desired size and a slicing process for cutting a semiconductor wafer, thereby manufacturing a semiconductor wafer.

### <Operation and effect>

The operation and effect according to the embodiment of the present invention will be described.

The apparatus of manufacturing a silicon carbide single crystal 1 according to the present embodiment includes the crucible main body 11, which is opened at the top and accommodates the sublimation material 50 in the bottom portion 11a, the cover member 12, which covers the upper opening 11b of the crucible main body 11 and is provided on the rear surface thereof with the seed crystal 60, and the cylindrical guide member 70 which is provided in the crucible main body 11 to guide the growth of a silicon carbide single crystal when the seed crystal 60 is grown to become the silicon carbide single crystal, wherein the guide member 70 includes a plurality of divided bodies, that is, the first divided body 74 and the second divided body 75.

Consequently, when taking the completely grown single crystal off from the guide member 70, it is possible to separate the first divided body 74 from the second divided body 75, and easily take the single crystal off from the guide member 70. Thus, it is possible to appropriately prevent the occurrence of the damage (e.g., a crack) of the single crystal.

In the apparatus of manufacturing a silicon carbide single crystal 1 according to the present embodiment, the gaps G (ou) and G (in) are provided between the first divided body 74 and the second divided body 75. Thus, it is possible to easily take the single crystal off from the guide member 70 by separating the first divided body 74 from the second divided body 75. Consequently, it is possible to appropriately prevent the occurrence of the damage (e.g., a crack) when taking the single crystal out from the guide member 70.

The method of manufacturing a silicon carbide single crystal according to the present embodiment includes a first step of generating the raw material gas G by heating and sublimating the sublimation material 50 including silicon carbide and accommodated in the crucible main body 11, a second step in which the seed crystal 60 receiving the raw material gas G via the guide member 70 including the first divided body 74 and the second divided body 75 is grown into a silicon carbide single crystal while being guided by the guide member 70, and a third step of taking off the grown silicon carbide single crystal after separating the first divided body 74 and the second divided body 75 from the grown silicon carbide single crystal.

In this way, since the first divided body 74 is separable from the second divided body 75, it is possible to more easily take the single crystal off from the guide member 70 and to further prevent the occurrence of the damage (e.g., a crack) of the single crystal.

### (Other embodiments)

As described above, the scope of the present invention has been disclosed through the embodiment of the present invention. However, it should be understood that those descriptions and drawings constituting a part of the present disclosure do not limit the present invention. From the present disclosure, various alternative embodiments, examples, and operational technologies will become apparent to those skilled in the art.

For example, the guide member 70 is divided into two, that is, the first divided body 74 and the second divided body 75. However, the guide member 70 may be divided into three or more divided bodies, and respective divided bodies may be detachably coupled to one another.

Further, in the embodiment, the protrusion outer peripheral surface 76b of the first protrusion 76 is brought into contact with the protrusion inner peripheral surface 77b of the second protrusion 77. However, the protrusion outer peripheral surface 76b and the protrusion inner peripheral surface 77b may be separated from each other in the radial direction and a gap may be provided to pass through between the first divided body 74 and the second divided body 75. In such a case, the raw material gas G enters the interior of the guide member 70 through the through gap.

As described above, it is of course that the present invention includes various embodiments and the like not described above. Accordingly, the technical scope of the present invention is determined only by the invention elements according to the scope of claims from the viewpoint of the above explanation.

### Example

Next, in order to clarify the effect of the present invention, experimental results performed using apparatuses of manufacturing a silicon carbide single crystal according to a conventional example and an example will be described.

The manufacturing apparatuses according to the example used the guide member 70 illustrated in Fig. 1 and the manufacturing apparatuses according to the conventional example used a single-piece guide member instead of a divided type guide member.

In the example, first, the sublimation material 50 was contained in the bottom portion 11a of the crucible main body 11 and the seed crystal 60 was attached to the rear surface of the cover member 12. A current was allowed to flow through the first induction heating coil 31, the second induction heating coil 32, and the interference preventive coil 33 to heat the sublimation material 50 up to about 2112°C for sublimation, thereby generating the raw material gas G. At this time, the pressure in the crucible 10 was held to 1 Torr by argon gas.

The raw material gas G rose and was collected to the seed crystal 60 while being guided by the cylindrical guide member 70. Since the seed crystal 60 was heated to the temperature of 2012°C which was lower than the heating temperature of the sublimation material 50, a silicon carbide single crystal was recrystallized on the seed crystal 60 and was grown. The grown silicon carbide single crystal and the guide member 70 were taken off, and the first divided body 74 and the second divided body 75 were taken off after separating them from the grown silicon carbide single crystal.

As described above, in the manufacturing apparatuses according to the example, the first divided body 74 and the second divided body 75 could be taken off from the completely grown single crystal, and a crack of the single crystal was prevented from occurring when taking off the guide member 70.

Meanwhile, in the manufacturing apparatuses according to the conventional example, since the guide member was formed in a single-piece, a crack occurred in the completely grown single crystal when taking the guide member off from the completely grown single crystal.

It is noted that the entire contents of Japanese Patent Application No. 2009-100295 (filed on April 16, 2009) are hereby incorporated in the present specification by reference.

### INDUSTRIAL APPLICABILITY

According to the present invention, since it is possible to divided the guide member when taking the completely grown single crystal off from the guide member, and to take the single crystal off from the guide member without giving the damage (e.g., a crack) to the single crystal, the present invention can be applied to an apparatus of manufacturing a sublimation recrystallization type silicon carbide single crystal.

### EXPLANATION OF NUMERALS

1 ... Manufacturing apparatus, 10 ... Graphite crucible, 11 ... Crucible main body, 11a ... Bottom portion, 11b ... Upper opening, 11c ... Inner side surface, 12 ... Cover member, 30 ... Induction heating coil, 31 ... First induction heating coil, 32 ... Second induction heating coil, 33 ... Interference preventive coil, 40 ... Support rod, 50 ... Sublimation material, 60 ... Seed crystal, 70 ... Guide member, 74 ... First divided body, 75 ... Second divided body, G ... Raw material gas, G(ou), G(in) ... Gap

## Claims

1. An apparatus of manufacturing a silicon carbide single crystal, comprising:
a crucible main body which is opened at a top and accommodates a sublimation material in a bottom portion;
a cover member which covers an upper opening of the crucible main body and is provided on a rear surface thereof with a seed crystal; and
a cylindrical guide member which is provided in the crucible main body to introduce a sublimated raw material gas from the sublimation material to the seed crystal and to guide growth of the silicon carbide single crystal when the silicon carbide single crystal is grown from the seed crystal, wherein
the guide member includes a plurality of divided bodies.

2. The apparatus of manufacturing a silicon carbide single crystal according to claim 1, wherein a gap is provided between the divided bodies.

3. A method of manufacturing a silicon carbide single crystal, the method comprising:
a first step of generating raw material gas by heating and sublimating a sublimation material including silicon carbide and accommodated in a crucible main body;
a second step of growing a seed crystal, which receives the raw material gas via a guide member including a plurality of divided bodies, into a silicon carbide single crystal while being guided by the guide member; and
a third step of taking off the grown silicon carbide single crystal after separating the plurality of divided bodies from the grown silicon carbide single crystal.
